(19) Europäisches Patentamt / European Patent Office / Office européen des brevets

(11) **EP 3 365 929 B1**

(12) **FASCICULE DE BREVET EUROPEEN**

(45) Date de publication et mention
de la délivrance du brevet:
**25.09.2019 Bulletin 2019/39**

(51) Int Cl.:
**H01L 41/313** (2013.01)    **H03H 9/02** (2006.01)

(21) Numéro de dépôt: **16795121.9**

(22) Date de dépôt: **17.10.2016**

(86) Numéro de dépôt international:
**PCT/FR2016/052674**

(87) Numéro de publication internationale:
**WO 2017/068269 (27.04.2017 Gazette 2017/17)**

(54) **PROCÉDÉ DE FABRICATION D'UNE STRUCTURE HYBRIDE**

VERFAHREN ZUR HERSTELLUNG EINER HYBRIDSTRUKTUR

METHOD FOR MANUFACTURING A HYBRID STRUCTURE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **20.10.2015 FR 1559993**

(43) Date de publication de la demande:
**29.08.2018 Bulletin 2018/35**

(73) Titulaire: **Soitec**
**38190 Bernin (FR)**

(72) Inventeur: **LANDRU, Didier**
**38190 Le Champ-pres-froges (FR)**

(74) Mandataire: **IP Trust**
**2, rue de Clichy**
**75009 Paris (FR)**

(56) Documents cités:
**WO-A1-2015/012005     US-A1- 2014 210 317**
**US-A1- 2015 042 207**

**Description**

**DOMAINE DE L'INVENTION**

La présente invention concerne le domaine de la fabrication de structures hybrides, notamment de structures comportant une couche de matériau piézoélectrique.

**ARRIERE PLAN TECHNOLOGIQUE DE L'INVENTION**

Dans le domaine des dispositifs à ondes acoustiques de surface ou de volume (respectivement « SAW » pour « Surface Acoustic Wave » et « BAW » pour « Bulk Acoustic Wave » selon la terminologie anglo-saxonne), les hétéro-structures comportant une couche de tantalate de lithium (LiTaO$_3$) disposée sur un substrat de silicium présentent un intérêt croissant : d'une part, parce qu'elles sont compatibles avec des équipements et procédés standard de la microélectronique grâce à leur substrat support en silicium, offrant des opportunités de croissance et de plus faibles coûts ; d'autre part parce qu'elles présentent des avantages techniques comme par exemple une moindre dépendance vis-à-vis de la température, de la réponse en fréquence des dispositifs SAW comme expliqué dans l'article de K.Hashimoto, M.Kadota et al., « Recent development of temperature compensated SAW devices », IEEE Ultrason. Symp. 2011, pages 79 à 86, 2011. Un exemple de l'art antérieur est le document US2015/042207.

Les hétéro-structures LiTaO$_3$/Si peuvent par exemple être élaborées à partir de l'assemblage par collage par adhésion moléculaire de deux substrats respectivement de LiTaO$_3$ et de Si. Pour la fabrication de dispositifs à ondes acoustiques sur ces hétéro-structures, il est avantageux de pouvoir appliquer une température supérieure à 200°C, voire 250°C, ceci pour permettre l'utilisation de matériaux et de procédés garantissant de bonnes performances des dispositifs. La tenue de l'interface de collage entre la couche de LiTaO$_3$ et le substrat support de Si est un des facteurs importants qui gèrent la bonne tenue mécanique de la structure en température et notamment au-delà de 200°C.

Il apparaît donc important de renforcer l'énergie de l'interface de l'hétéro-structure préalablement aux étapes de fabrication du dispositif à ondes acoustiques ; dans le cas d'une hétéro-structure fabriquée par collage par adhésion moléculaire d'une couche sur un substrat support, l'interface de collage peut en particulier être renforcée par application d'un traitement thermique dans une gamme de température autour de 200-300°C. Se pose donc le problème d'appliquer un tel traitement thermique à l'hétéro-structure sans endommager celle-ci du fait de la différence significative de coefficient de dilatation thermique (CTE pour « Coefficient of Thermal Expansion » selon la terminologie anglo-saxonne) des deux matériaux.

Par ailleurs, lorsqu'une hétéro-structure comportant une très fine couche de LiTaO$_3$ est requise (par exemple pour la fabrication de dispositifs à ondes acoustiques de volume), une solution est de transférer ladite couche par le procédé Smart Cut®, incluant la formation d'un plan fragile enterré dans un substrat donneur de LiTaO$_3$ par introduction d'espèces légères telles que l'hydrogène ou l'hélium, le collage direct (par adhésion moléculaire) de ce substrat donneur sur un substrat support en silicium, et le détachement au niveau du plan fragile enterré de manière à transférer une couche superficielle de LiTaO$_3$ sur Si. Il est connu que la couche superficielle après transfert comprend encore des défauts et des espèces légères dans son épaisseur. Il est donc avantageux, pour guérir cette couche de réaliser un recuit dans une gamme adaptée de température : pour permettre la guérison des défauts et l'évacuation des espèces légères, mais sans endommager les qualités de la couche mince transférée ou la tenue mécanique de l'hétéro-structure. A titre d'exemple, pour une couche de LiTaO$_3$, la gamme de températures adaptée est comprise entre 400° et 600°C.

Le problème à nouveau est que les hétéro-structures LiTaO$_3$/Si, compte tenu du très grand écart de coefficient de dilatation thermique entre les deux matériaux, supportent difficilement ces budgets thermiques élevés.

Lors de la fabrication de structures hybrides ou hétéro-structures, il est d'usage de réaliser les traitements thermiques présentant une température élevée lorsque la couche superficielle disposée sur le substrat support est la plus fine possible, de manière à limiter les contraintes et les déformations (se traduisant notamment par une courbure du substrat) dans ladite structure hybride. On peut citer à titre d'exemple les structures hybrides de type silicium sur silice massive ou silicium sur saphir, qui peuvent supporter des recuits de l'ordre de 850°C lorsque l'épaisseur de la couche superficielle de silicium est inférieure à environ 100nm et l'épaisseur du substrat de silice massive de l'ordre de 700 microns, sans subir de dommages prohibitifs. Pour des épaisseurs supérieures de la couche superficielle, typiquement 1 micron, la température maximale applicable sans dommage diminue par exemple autour de 600°C. Pour des épaisseurs encore bien supérieures de la couche supérieure, par exemple 700 microns, la température maximale applicable sans dommage diminue par exemple autour de 100-150°C.

Pour une structure hybride composée d'une couche de LiTaO$_3$ (par exemple de 10 microns d'épaisseur) disposée sur un substrat de silicium (par exemple de 150mm de diamètre et 625 microns d'épaisseur), la demanderesse a utilisé ces connaissances de l'état de l'art : elle a appliqué la température de recuit requise pour renforcer l'interface de collage (soit 250°C) à la structure hybride finale (10 microns LiTaO$_3$ sur 625 microns Si), c'est-à-dire comportant la couche superficielle la plus fine possible. La demanderesse a alors observé des résultats inattendus : une dégradation importante de la couche par un phénomène dit de « buckling » correspondant à la déformation par flambage local de la couche de LiTaO$_3$, rendant la structure hybride inutilisable.

**OBJET DE L'INVENTION**

Un objet de l'invention est donc de proposer un procédé de fabrication d'une structure hybride remédiant aux inconvénients de l'art antérieur. Un objet de l'invention est notamment de proposer un procédé permettant l'application d'un traitement thermique requis sans endommager la structure hybride.

**BREVE DESCRIPTION DE L'INVENTION**

L'invention concerne un procédé de fabrication d'une structure hybride comportant une couche utile de matériau piézoélectrique présentant une épaisseur utile disposée sur un substrat support présentant une épaisseur support et un coefficient de dilatation thermique inférieur à celui de la couche utile, le procédé comprenant :

a) Une étape de fourniture d'une structure collée comportant un substrat donneur de matériau piézoélectrique et le substrat support, la structure collée présentant une interface de collage entre ces deux substrats ;
b) Une première étape d'amincissement du substrat donneur pour former une couche amincie, présentant une épaisseur intermédiaire, disposée sur le substrat support ; l'ensemble formant une structure amincie ;
c) Une étape de traitement thermique de la structure amincie à une température de recuit;
d) Une seconde étape d'amincissement, après l'étape c), de la couche amincie pour former la couche utile ;

le procédé étant remarquable en ce qu'il comprend, préalablement à l'étape b), une étape a') de détermination d'une fourchette d'épaisseurs intermédiaires évitant une dégradation de la structure amincie (6') lors de l'étape c), la fourchette étant définie par une épaisseur seuil et une épaisseur plafond, et l'épaisseur intermédiaire de la couche amincie étant choisie dans cette fourchette.

Le procédé de fabrication selon l'invention permet ainsi d'appliquer un traitement thermique à une température de recuit requise pour consolider l'interface de collage ou pour guérir tout ou partie de défauts présents dans la couche amincie (qui deviendra la couche utile), à une structure amincie pour laquelle on a préalablement déterminé la fourchette d'épaisseurs compatibles de la couche amincie. Ledit traitement thermique n'est en général pas applicable à la structure hybride finale c'est-à-dire avec la couche utile à son épaisseur utile, sans générer un endommagement de la couche utile, notamment quand des zones non collées (défauts de collage ou motifs gravés préexistants sur les faces assemblées des substrats) sont présentes à l'interface de collage.

Selon des caractéristiques avantageuses de l'invention, prises seules ou en combinaison :

- l'épaisseur seuil est déterminée à partir d'un premier modèle de sensibilité dont des paramètres d'entrée incluent l'épaisseur support, les coefficients de dilatation thermique du substrat donneur et du substrat support, la température de recuit et une taille maximale de zones non collées présentes à l'interface de collage de la structure collée ;
- l'épaisseur plafond est déterminée à partir d'un second modèle de sensibilité dont des paramètres d'entrée incluent l'épaisseur support, les coefficients de dilatation thermique du substrat donneur et du substrat support et la température de recuit ;
- le procédé de fabrication comprend après l'étape a') et préalablement à l'étape b), une étape a") de recyclage de la structure collée, quand l'étape a') de détermination établit l'épaisseur seuil supérieure à l'épaisseur plafond ou l'épaisseur plafond inférieure à l'épaisseur utile ;
- l'étape a") de recyclage comprend un décollement au niveau de l'interface de collage de la structure collée ;
- l'étape a") de recyclage comprend la réutilisation des substrats donneur et support issus du décollement pour une nouvelle étape a) de fourniture d'une structure collée ;
- la seconde étape d'amincissement d) peut en outre comprendre une étape d'amincissement du substrat support ;
- la couche utile est composée d'un matériau choisi dans le groupe : tantalate de lithium (LiTaO$_3$), niobate de lithium (LiNbO$_3$), nitrure d'aluminium (AlN), oxyde de zinc (ZnO) ;
- le substrat support est composé d'un matériau choisi dans le groupe : silicium, semi-conducteurs III-V, carbure de silicium, verre, saphir ;
- le substrat support comprend une ou plusieurs couches superficielles.

L'invention concerne en outre une structure hybride comportant une couche utile de matériau piézoélectrique d'épaisseur utile inférieure à 50 microns assemblée à un substrat support présentant un coefficient de dilatation thermique inférieur à celui de la couche utile, la structure hybride étant caractérisée en ce qu'une interface de collage entre la couche utile et le substrat support présente une énergie de collage supérieure à 1000 mJ/m$^2$ et au moins une zone non collée dont la taille est comprise entre 1 et 1000 microns.

**BREVE DESCRIPTION DES DESSINS**

D'autres caractéristiques et avantages de l'invention ressortiront de la description détaillée de l'invention qui va suivre en référence aux figures annexées sur lesquelles :

- les figures 1a à 1c présentent un procédé de fabrication d'une structure hybride conforme à l'invention ;
- les figures 2a à 2c présentent trois configurations différentes de fourchettes d'épaisseurs, versus l'épaisseur utile, issues d'une étape de détermination conforme à l'invention ;
- la figure 3 présente différentes étapes du procédé de fabrication conforme à l'invention.

**DESCRIPTION DETAILLEE DE L'INVENTION**

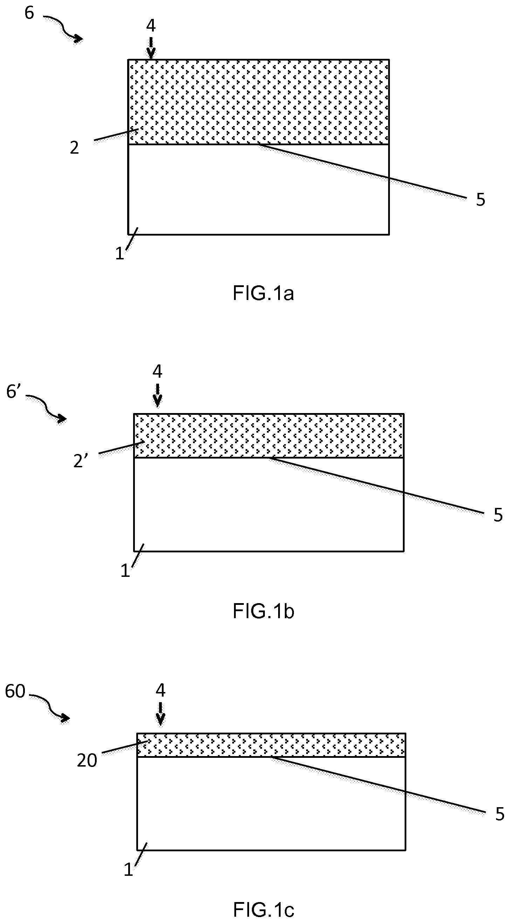

L'invention concerne un procédé de fabrication d'une structure hybride 60 comportant une couche utile 20 de matériau piézoélectrique disposée sur un substrat support 1 présentant une épaisseur support et un coefficient de dilatation thermique inférieur à celui de la couche utile 20 (figure 1c).

Le procédé comprend une étape a) de fourniture d'une structure collée 6 comportant un substrat donneur 2 de matériau piézoélectrique et le substrat support 1. La structure collée 6 présente une interface de collage 5 entre ces deux substrats 1,2 (figure 1a). A titre d'exemple, le substrat donneur 2 peut être composé d'un matériau choisi dans le groupe : tantalate de lithium ($LiTaO_3$), niobate de lithium ($LiNbO_3$), nitrure d'aluminium (AlN), oxyde de zinc (ZnO). Le substrat support peut être composé d'un matériau choisi dans le groupe : silicium, semi-conducteurs III-V, carbure de silicium, verre, saphir. L'un et/ou l'autre des substrats 1,2 pourra optionnellement comporter des composants (tout ou partie de circuits micro-électroniques) ou des motifs gravés sur leur face à assembler : les composants pourront être formés de couches empilées de différentes natures et présentant des motifs ; les motifs gravés pourront être formés par des cavités destinées à assurer une fonction dans le dispositif final élaboré sur la structure hybride 60. L'assemblage de la structure collée 6 est avantageusement réalisé par collage par adhésion moléculaire, entre le substrat donneur 2 et le substrat support 1. Optionnellement, une couche intermédiaire, comme par exemple une couche d'oxyde de silicium, de nitrure de silicium ou autre couche favorisant un collage par adhésion moléculaire, peut être ajoutée sur l'un des deux substrats ou les deux avant assemblage. Avantageusement, les substrats 1,2 sont également soumis à des étapes de nettoyage et/ou d'activation de surface avant assemblage, pour favoriser la qualité et l'énergie de l'interface de collage 5 formée après assemblage.

On appellera par la suite « zone non collée » une zone localisée, à l'interface de collage, au niveau de laquelle les surfaces des deux substrats ne sont pas intimement en contact, à l'exclusion de la couronne périphérique non collée en bords des substrats assemblés qui forme une zone d'exclusion. Une « zone non collée » est donc typiquement entourée par une zone collée. Une zone non collée pourra être liée à un défaut de collage, par exemple dû à la présence d'une particule ou autre contamination (hydrocarbure ou autre) à l'interface de collage 5 de la structure collée 6. Elle pourra également être liée à la présence d'un motif gravé ou d'une topographie locale sur le substrat donneur 2 ou le substrat support 1, dû à la présence de composants ou de cavités ou encore de marques laser (par exemple pour assurer la traçabilité des substrats) sur leurs faces respectives à assembler.

Après l'étape d'assemblage, le procédé comprend une étape b) correspondant à une première étape d'amincissement du substrat donneur 2 pour former une couche amincie 2', présentant une épaisseur intermédiaire, disposée sur le substrat support 1 ; l'ensemble formant une structure amincie 6' (figure 1b). Le substrat donneur 2 est aminci au niveau de sa face arrière 4, par des techniques d'amincissement mécanique, mécano-chimique et/ou de gravure chimique ou encore par un procédé de type Smart Cut®, bien connu de l'homme du métier. A titre d'exemple, le substrat donneur 2 peut être aminci par « grinding » (amincissement mécanique) puis par polissage mécano-chimique. Cette étape d'amincissement précède une étape c) de traitement thermique dont la fonction peut être de consolider l'interface de collage 5 ou de guérir des défauts dans la couche amincie 2' qui deviendra la couche utile 20. Il est ainsi important que l'étape b) d'amincissement mène à l'obtention d'une structure amincie 6' compatible avec le traitement thermique requis à l'étape c) suivante.

A cet effet, le procédé de fabrication est remarquable en ce qu'il comprend une étape a'), préalable à l'étape b) d'amincissement, de détermination d'une fourchette d'épaisseurs intermédiaires pour la couche amincie 2', visant à éviter une dégradation de la structure amincie lors de l'étape c) de traitement thermique. Ladite fourchette est définie par une épaisseur seuil et une épaisseur plafond, l'épaisseur intermédiaire de la couche amincie 2' est ainsi choisie dans cette fourchette.

L'épaisseur seuil est déterminée à partir d'un premier modèle de sensibilité dont les paramètres d'entrée incluent l'épaisseur support (du substrat support 1), les coefficients de dilatation thermique du substrat donneur 2 et du substrat support 1, la température de recuit requise à l'étape c) de traitement thermique et une taille maximale de zones non collées présentes à l'interface de collage 5 de la structure collée 6.

Le premier modèle de sensibilité est établi à partir d'une équation traduisant la relaxation d'une couche mince en compression sur un substrat. Un phénomène de relaxation d'une couche mince tel que le « buckling » (flambage) nécessite la présence d'une zone non collée à l'interface entre la couche mince et le substrat. La contrainte critique $\sigma_{buckling}$ nécessaire pour initier cette relaxation de la couche mince, qui correspond à la déformation par flambage local de ladite couche, peut s'exprimer comme :

$$\sigma_{buckling} = \frac{\pi^2}{12}\frac{E_2}{(1-v_2^2)}\left(\frac{h_2}{r}\right)^2$$

$$\{equ.1\}$$

avec $E_2$ le module d'Young de la couche mince, $v_2$ le coefficient de Poisson de la couche mince, $h_2$ l'épaisseur de la couche mince et r le rayon de la zone non collée entre la couche mince et le substrat. La contrainte traduit une force appliquée par unité de surface sur la section (longueur x épaisseur) de la couche mince. Pour s'affranchir de la longueur de ladite section et ne considérer que l'épaisseur $h_2$ de la couche mince, on peut exprimer une force critique normalisée par la longueur, $F_{buckling}^{norm.}$ en N/m :

$$F_{buckling}^{norm.} = \sigma_{buckling}.h_2 = \frac{\pi^2}{12}\frac{E_2.h_2}{(1-v_2^2)}\left(\frac{h_2}{r}\right)^2$$

$$\{equ.2\}$$

Considérons que la couche mince correspond à la couche amincie 2' : $E_2$, $v_2$ sont donc respectivement le module d'Young et le coefficient de Poisson du matériau piézoélectrique constituant la couche amincie 2' ; $h_2$ est l'épaisseur intermédiaire et r est le rayon maximal des zones non collées présentes à l'interface de collage 5 de la structure collée 6. La taille des zones non collées présentes à l'interface de collage 5 pourra par exemple être déterminée par imagerie en lumière blanche ou en infra-rouge selon les matériaux constitutifs de la structure collée 6, ou encore par microscopie acoustique, technique particulièrement avantageuse pour détecter les zones non collées de petite taille. Le rayon maximal des zones non collées à l'interface de collage 5 (pouvant être liées à des défauts de collage ou à des motifs préexistants sur l'une ou l'autre des faces assemblées des substrats donneur 2 et support 1) pourra ainsi être extrait pour chaque structure collée 6.

L'équation {equ.2} montre que le phénomène de « buckling » sera d'autant plus facile à initier (cad requerra une force normalisée $F_{buckling}^{norm.}$ plus faible) que l'épaisseur intermédiaire $h_2$ de la couche amincie 2' sera faible et que le rayon maximal r des zones non collées sera grand.

On connaît par ailleurs l'épaisseur support $h_1$ du substrat support 1 ainsi que ses caractéristiques mécaniques ($E_1$, son module d'Young) ; on connaît également la température de recuit requise à appliquer à la structure amincie 6' au cours de l'étape c) de traitement thermique. On peut donc exprimer la force en compression normalisée $F^{norm.}$ qui s'appliquera à la couche amincie 2' au cours du traitement thermique de l'étape c) :

$$F^{norm.} = \frac{(E_1.h_1^3 + E_2.h_2^3)}{6(h_1 + h_2).\rho}$$

$$\{equ.3\}$$

avec p le rayon de courbure de la structure amincie 6':

$$\frac{1}{\rho} = \frac{\Delta CTE.\Delta T}{K(h1,h2)}$$

$$\{equ.4\}$$

avec $\Delta CTE$ la différence entre les coefficients de dilatation thermique des matériaux respectifs de la couche amincie 2' et du substrat support 1 ; $\Delta T$ le delta de température entre température ambiante et température de recuit appliquée ; et le terme $K(h_1,h_2)$ qui s'exprime comme :

$$K(h_1,h_2) = \frac{h_1 + h_2}{2} + \frac{(E_1.h_1^3 + E_2.h_2^3)}{6(h_1 + h_2)}.\left(\frac{1}{E_1.h_1} + \frac{1}{E_2.h_2}\right)$$

$$\{equ.5\}$$

L'épaisseur seuil de la fourchette peut ainsi être déterminée en posant $F^{norm.} = F_{buckling}^{norm.}$, par résolution de l'équation {equ.5} :

$$\frac{(E_1.h_1^3 + E_2.h_{2seuil}^3).\Delta CTE.\Delta T}{6(h_1 + h_{2seuil}).K(h_1,h_{2seuil})} = \frac{\pi^2}{12}\frac{E_2.h_{2seuil}}{(1 - \nu_2^2)}\left(\frac{h_{2seuil}}{r}\right)^2$$

$$\{equ.6\}$$

avec $h_{2seuil}$ ladite épaisseur seuil.

L'épaisseur seuil correspond à l'épaisseur intermédiaire en-dessous de laquelle le phénomène de « buckling » a une forte probabilité d'apparaître, compte tenu des caractéristiques de la structure amincie 6' (type de matériaux la constituant, taille maximale de zones non collées présentes à l'interface de collage 5, épaisseur du substrat support) et de la température de recuit devant être appliquée au cours du traitement thermique de l'étape c). Notons que le phénomène de « buckling » peut également s'accompagner d'un élargissement de la zone non collée, préférentiellement perpendiculairement aux axes cristallographiques ayant le coefficient de dilatation le plus élevé. Cet élargissement peut être d'autant plus important que l'énergie de l'interface de collage 5 est faible. La consolidation de l'énergie de l'interface de collage 5, dans une configuration évitant l'apparition du « buckling » est donc à plus forte raison importante.

Le premier modèle de sensibilité relie ainsi l'épaisseur seuil à un ensemble de paramètres caractéristiques de la structure amincie 6' et aux contraintes thermiques qu'elle doit subir.

L'épaisseur plafond est déterminée à partir d'un second modèle de sensibilité dont les paramètres d'entrée incluent l'épaisseur support (du substrat support 1), les coefficients de dilatation thermique du substrat donneur 2 et du substrat support 1 et la température de recuit requise à l'étape c) de traitement thermique.

Le second modèle de sensibilité est établi à partir d'une équation traduisant la rupture du matériau constituant le substrat support 1, contraint en extension dans la structure amincie 6' au cours d'un traitement thermique. L'énergie élastique E stockée dans le substrat support 1, dans le cas d'une structure amincie 6' comportant une couche amincie 2' et un substrat support 1 de nature différente et à laquelle est appliqué un traitement thermique, s'exprime ainsi :

$$E = \frac{1}{E_1}\left(\frac{(F^{norm.})^2}{h_1} + \frac{E_1^2.h_1^3}{12.\rho^2}\right)$$

$$\{equ.7\}$$

La rupture du matériau constituant le substrat support 1 apparaît quand l'énergie élastique E dépasse une valeur critique donnée par :

$$E_{rupture} = \frac{K_{1c}^2}{E_1}$$

{equ.8}

avec $K_{1c}$ la ténacité du matériau constituant le substrat support 1.

L'épaisseur plafond de la fourchette peut ainsi être déterminée en posant $E = E_{rupture}$, par résolution de l'équation :

$$\left( \frac{1}{h_1} \left[ \frac{(E_1.h_1^3 + E_2.h_{2plafond}^3).\Delta CTE.\Delta T}{6(h_1 + h_{2plafond}).K(h_1, h_{2plafond})} \right]^2 + \frac{E_1^2.h_1^3.(\Delta CTE.\Delta T)^2}{12.\left[ K(h_1, h_{2plafond}) \right]^2} \right) = K_{1c}^2$$

{equ.9}

avec $h_{2plafond}$ ladite épaisseur plafond.

L'épaisseur plafond correspond à l'épaisseur intermédiaire de la couche amincie 2' au-dessus de laquelle la rupture du substrat support 1 a une forte probabilité d'apparaître, compte tenu des caractéristiques de la structure amincie 6' (type de matériaux la constituant, épaisseur du substrat support 1) et de la température de recuit devant être appliquée au cours du traitement thermique de l'étape c).

Le second modèle de sensibilité relie ainsi l'épaisseur plafond à un ensemble de paramètres caractéristiques de la structure amincie 6' et aux contraintes thermiques qu'elle doit subir.

Une structure hétérogène telle que la structure amincie 6' subit des contraintes et des déformations lorsqu'elle est soumise à un traitement thermique, du fait des dilatations différentielles des deux matériaux la constituant. Elle se déforme en adoptant une courbure pouvant mener à différents modes de défaillance : la casse du substrat support 1, le flambage local (« buckling ») de la couche amincie 2', la formation de dislocations ou de plans de glissement dans la structure (en particulier dans la couche amincie 2'), le décollement au niveau des bords de la structure amincie 6', etc... Expérimentalement, la demanderesse a constaté que, dans le cas de structures amincies 6' comportant une couche de matériau piézoélectrique et un substrat support d'un matériau ayant un coefficient de dilatation thermique inférieur, les deux modes de défaillances prépondérants étaient d'une part, la casse du substrat support 1 (phénomène de rupture du matériau au-delà de l'énergie critique de rupture) et d'autre part, le flambage local, au niveau de zones non-collées, de la couche amincie 2' (phénomène de relaxation d'une couche mince en compression, dit de « buckling »). Les deux modèles de sensibilité établis par la demanderesse à partir des équations {equ.6} et {equ.9} sont donc bien adaptés à la détermination de fourchettes d'épaisseurs pour la couche amincie 2', dans le cas de structures amincies hétérogènes 6' dont ladite couche amincie 2' est formée d'un matériau piézoélectrique.

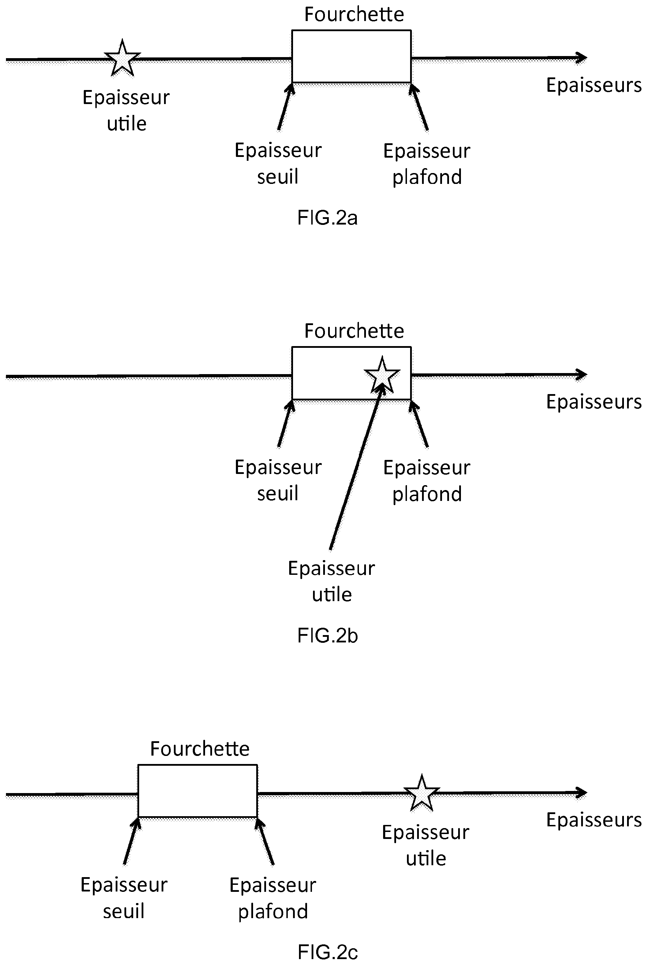

A la suite de l'étape a'), on obtient donc une fourchette d'épaisseurs définie par l'épaisseur seuil et l'épaisseur plafond déterminées, comme illustré sur les figures 2a à 2c.

Selon une première variante de mise en oeuvre du procédé de fabrication, l'épaisseur utile de la couche utile 20 attendue pour la structure hybride 60 finale est inférieure à la fourchette d'épaisseurs définie (figure 2a) : on est dans un cas de fourchette d'épaisseurs compatibles avec la structure finale envisagée. Le procédé de fabrication selon l'invention comporte, comme évoqué précédemment, l'étape b) d'amincissement du substrat donneur 2 pour former la couche amincie 2', après l'étape a') de détermination de la fourchette d'épaisseurs compatible. L'épaisseur intermédiaire de la couche amincie 2' sera alors choisie de manière à être comprise dans ladite fourchette, c'est-à-dire entre l'épaisseur seuil et l'épaisseur plafond. Le procédé comprend ensuite l'étape c) de traitement thermique à la température de recuit requise pour la structure amincie 6'. A titre d'exemple, cette température de recuit pourra varier entre 200°C et 600°C selon le type de structure hybride attendu et selon l'objectif de ce traitement thermique : consolidation de l'interface de collage 5, guérison de défauts ou exo-diffusion d'espèces légères dans l'épaisseur de la couche amincie 2' (destinée à devenir la couche utile 20), etc. Le traitement thermique pourra comporter une entrée et une sortie du four à basse température par exemple 100°C, une rampe de montée et de descente en température, par exemple entre 0,5 et 5°/min, et un palier à la température de recuit requise, par exemple entre 200°C et 600°C, pendant une durée allant de 30min à quelques heures.

Après l'étape c) de traitement thermique, le procédé comporte une étape d) correspondant à une seconde étape d'amincissement de la couche amincie 2' pour former la couche utile 20 présentant une épaisseur utile, disposée sur le substrat support 1 ; l'ensemble formant la structure hybride 60 finale (figure 1c). La couche 2' est donc à nouveau amincie, au niveau de sa face arrière 4, par des techniques d'amincissement mécanique, mécano-chimique et/ou de gravure chimique et/ou amincissement par le procédé Smart Cut®. A titre d'exemple, la couche 2' peut être amincie par des séquences de polissage mécano-chimique, suivies d'un nettoyage. La structure hybride 20 ainsi formée peut ensuite être utilisée pour l'élaboration de dispositifs électroniques, ses propriétés (énergie de collage de l'interface de collage 5 et/ou qualité de la couche utile 20) ayant été améliorées par la réalisation du procédé selon l'invention. Habituellement, les étapes d'élaboration des dispositifs ne nécessitent pas l'application de traitements thermiques à une température aussi élevée que la température de recuit de l'étape c) du procédé.

Selon une deuxième variante de mise en oeuvre du procédé de fabrication, l'épaisseur utile de la couche utile 20 attendue pour la structure hybride 60 finale est comprise dans la fourchette d'épaisseurs définie (figure 2b) ; on est dans un cas de fourchette d'épaisseurs compatibles avec la structure finale envisagée. Le procédé de fabrication selon l'invention comporte, comme évoqué précédemment, l'étape b) d'amincissement du substrat donneur 2 pour former la couche amincie 2', après l'étape a'). L'épaisseur intermédiaire de la couche amincie 2' sera avantageusement choisie de manière à être comprise dans la fourchette, et en particulier, elle sera choisie égale ou sensiblement supérieure à l'épaisseur utile. Le procédé comprend ensuite l'étape c) de traitement thermique à la température de recuit requise pour la structure amincie 6'. A titre d'exemple, cette température de recuit pourra varier entre 200°C et 600°C selon le type de structure hybride 60 attendu et selon l'objectif de ce traitement thermique.

Après l'étape c) de traitement thermique, le procédé comporte une étape d) correspondant à une seconde étape d'amincissement de la couche amincie 2' pour former la couche utile 20 présentant une épaisseur utile, disposée sur le substrat support 1 ; l'ensemble formant la structure hybride 60 finale. Selon cette deuxième variante de mise en oeuvre, l'étape b) d'amincissement de la couche amincie amène déjà l'épaisseur intermédiaire sensiblement à l'épaisseur utile. L'étape d) pourra ainsi consister essentiellement en une étape de polissage à faible enlèvement (« touch polishing » selon la terminologie anglo-saxonne) et en des séquences de nettoyage, permettant d'améliorer l'état de surface de la face 4 de la couche utile 20. La structure hybride 20 ainsi formée peut ensuite être utilisée pour l'élaboration de dispositifs électroniques, en particulier de dispositifs à ondes acoustiques.

Selon une troisième variante de mise en oeuvre du procédé de fabrication selon l'invention, l'épaisseur utile de la couche utile 20 attendue pour la structure hybride 60 finale est supérieure à la fourchette d'épaisseurs définie (figure 2c), autrement dit l'épaisseur utile est supérieure à l'épaisseur plafond. Cette configuration traduit le fait que la fourchette d'épaisseurs définie (déterminée grâce aux modèles de sensibilité et à partir des caractéristiques de la structure collée 6 et de la température de recuit requise) est incompatible avec la structure hybride 20 finale attendue.

Cette configuration de fourchette d'épaisseurs incompatible avec la structure hybride 20 attendue (figure 2c) peut être liée au fait que l'épaisseur support est insuffisante. Le procédé de fabrication selon l'invention comporte alors une étape a") de recyclage de la structure collée 6. L'étape a") consiste à réaliser le décollement de la structure collée 6 au niveau de l'interface de collage 5, menant à la séparation du substrat donneur 2 et du substrat support 1. Ce décollement peut être effectué par insertion d'un outil en forme de biseau entre les bords chanfreinés des deux substrats donneur 2 et support 1 de la structure collée 6. Après le décollement, l'étape a") de recyclage comprend en outre la réutilisation des substrats donneur 2 et support 1 décollés pour une nouvelle étape a) de fourniture d'une structure collée 6. L'étape a") de recyclage peut être mise à profit pour utiliser un substrat support 1 d'épaisseur plus importante et fournir une nouvelle structure collée 6. Cette augmentation de l'épaisseur support permettra notamment d'augmenter la valeur d'épaisseur plafond, l'objectif étant de retrouver une fourchette d'épaisseurs compatible c'est-à-dire avec une épaisseur plafond supérieure à l'épaisseur utile attendue. La seconde étape d'amincissement d) selon le procédé comportera en outre, dans ce cas, une étape d'amincissement de la face arrière du substrat support 1, de manière à le ramener à l'épaisseur support requise pour la structure hybride 60 finale. Cette étape d'amincissement supplémentaire pourra consister en un amincissement mécanique, mécano-chimique ou chimique.

La configuration dans laquelle la fourchette d'épaisseurs est incompatible avec la structure hybride 20 attendue (figure 2c) peut également être liée au fait que la température de recuit est trop élevée. On peut alors choisir de diminuer la température de recuit à appliquer à l'étape c) de traitement thermique. L'étape a") de recyclage peut également être mise à profit pour appliquer une préparation de surface différente (pouvant être potentiellement plus complexe ou couteuse mais nécessaire dans ce cas de figure) aux substrats 1 et 2 avant leur assemblage, permettant par exemple de favoriser l'énergie de collage après un traitement thermique à plus basse température. Une nouvelle fourchette d'épaisseurs est alors déterminée avant de poursuivre le procédé.

Selon une quatrième variante de mise en oeuvre du procédé de fabrication, l'épaisseur seuil déterminée à l'étape a') est supérieure à l'épaisseur plafond déterminée à la même étape (configuration non représentée). Dans ce cas de figure, la fourchette d'épaisseur est également considérée comme incompatible avec la structure attendue, puisqu'elle n'existe pas (la fourchette d'épaisseur étant définie par une épaisseur seuil inférieure à une épaisseur plafond). Il se peut dans ce cas que la taille maximale des zones non collées présentes à l'interface de collage 5 soit trop grande pour autoriser une fourchette d'épaisseurs compatible. Le procédé de fabrication selon l'invention comporte alors une étape a") de recyclage de la structure collée 6. L'étape a") consiste à réaliser le décollement de la structure collée 6 au niveau de l'interface de collage 5, menant à la séparation du substrat donneur 2 et du substrat support 1. Ce décollement peut être effectué par application d'une contrainte à l'interface entre les deux substrats donneur 2 et support 1 de la structure collée 6. Après le décollement, l'étape a") de recyclage comprend la réutilisation des substrats donneur 2 et support 1 décollés pour une nouvelle étape a) de fourniture d'une structure collée 6. Dans l'hypothèse que la zone non collée de taille maximale était relative à un défaut de collage, l'étape de recyclage a") peut permettre d'éliminer ce défaut par un nouveau nettoyage et une nouvelle préparation des surfaces des substrats 1,2 à assembler.

Si la taille des zones non collées présentes à l'interface de collage 5 est difficile à réduire (dans le cas par exemple de motifs ou cavités préexistantes sur l'un des deux substrats assemblés et ayant une fonction particulière), l'étape a") de recyclage peut être par exemple mise à profit pour utiliser modifier les conditions d'assemblage pour permettre de limiter ultérieurement la température requise à appliquer à l'étape c) et fournir une nouvelle structure collée 6.

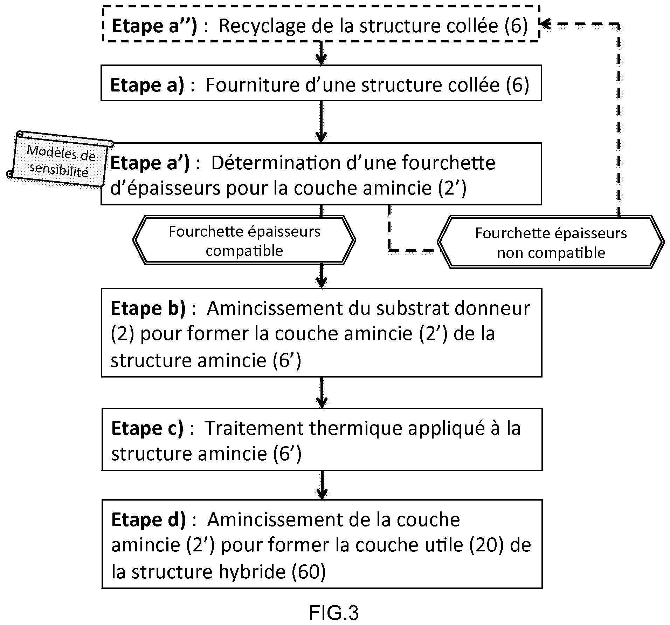

Les principales étapes du procédé selon l'invention sont illustrées sur la figure 3.

Le procédé de fabrication selon l'invention permet d'appliquer un traitement thermique à une température de recuit requise pour consolider l'interface de collage 5 ou pour guérir des défauts dans la couche amincie 2' (qui deviendra la couche utile 20), à une structure amincie 6' pour laquelle on a préalablement déterminé la fourchette d'épaisseurs compatibles pour la couche amincie 2'. Ledit traitement thermique n'est en général pas applicable à la structure hybride 60 finale c'est-à-dire avec la couche utile 20 à son épaisseur utile, sans générer un endommagement de la couche utile 20, notamment quand des zones non collées (défauts de collage ou motifs gravés préexistants sur les faces assemblées des substrats 1,2) sont présentes à l'interface de collage 5.

Par ailleurs, l'étape a') de détermination de la fourchette d'épaisseurs compatibles permet d'identifier quand il est nécessaire de recycler la structure collée 6, et ce avant d'engager l'étape d'amincissement b), elle permet ainsi d'augmenter les rendements de fabrication.

L'invention concerne également une structure hybride 60 comportant une couche utile 20 de matériau piézoélectrique d'épaisseur utile inférieure à 50 microns assemblée à un substrat support 1 présentant un coefficient de dilatation thermique inférieur à celui de la couche utile 20 (figure 1c). L'interface de collage 5 entre la couche utile 20 et le substrat support 1 présente une énergie de collage supérieure ou égale à 1000 mJ/m$^2$ et au moins une zone non collée dont la taille est comprise entre 1 et 1000 microns. La couche utile 20 est composée d'un matériau choisi dans le groupe : tantalate de lithium (LiTaO$_3$), niobate de lithium (LiNbO$_3$), nitrure d'aluminium (AlN), oxyde de zinc (ZnO), etc. A titre d'exemple son épaisseur est comprise entre 0,1 micron et 50 microns. Le substrat support 1 est composé d'un matériau choisi dans le groupe : silicium, semi-conducteurs III-V, carbure de silicium, verre, saphir, etc. A titre d'exemple, son épaisseur est comprise entre 300 et 1000 microns. Le substrat support peut également comprendre une ou plusieurs couches superficielles de différentes natures. A titre d'exemple, le substrat support pourra consister en un substrat en silicium monocristallin comportant une couche superficielle du côté de sa face à assembler, apte à piéger des charges, en particulier en silicium polycristallin, ; il pourra également consister en un substrat SOI (silicium sur isolant) dont les couches superficielles sont en oxyde de silicium et en silicium ou encore en un substrat SOI muni d'une couche de piégeage de charges sous la couche d'oxyde.

Exemple 1 :

Un substrat support 1 en silicium (Si) de 150mm de diamètre, d'épaisseur 725 microns, comporte des motifs gravés à espacement régulier sur toute sa face à assembler. Ces motifs pourront par exemple avoir une fonction de marques d'alignement ou constituer des cavités servant à la fabrication de membranes suspendues ou encore constituer des contacts électriques dans la structure hybride 60 finale, sur laquelle seront élaborés les dispositifs. Le substrat support 1 comporte également une couche d'oxyde sur sa face à assembler. Il est collé par adhésion moléculaire avec un substrat donneur 2 en tantalate de lithium (LiTaO$_3$) de même diamètre pour fournir la structure collée 6. Une étape de contrôle par microscopie acoustique permet de détecter et de mesurer les zones non collées à l'interface de collage 5, générées par les motifs. La taille maximale de zones non collées correspond à un rayon r de 500 microns.

La structure hybride 60 finale attendue comporte une couche utile 20 de 10 microns et un substrat support de 725 microns. La température de recuit à appliquer est 230°C, dans le but de consolider suffisamment l'interface de collage 5 pour que la structure hybride 60 supporte les étapes subséquentes d'élaboration des dispositifs à ondes acoustiques.

L'étape a') permet de déterminer des épaisseurs seuil et plafond : $h_{2seuil}$ = 28 $\mu$m et $h_{2plafond}$ = 32 $\mu$m. La fourchette d'épaisseur obtenue est compatible avec la structure hybride 60 attendue, l'épaisseur utile étant inférieure à ladite fourchette.

L'étape b) d'amincissement, consistant en un amincissement mécanique suivi d'un polissage mécano-chimique et d'un nettoyage chimique, permet de former une couche amincie 2' dont l'épaisseur intermédiaire est de 30 $\mu$m. Le traitement thermique de l'étape c) est ensuite effectué. L'entrée dans le four s'effectue à 100°C, la rampe de montée en température est de 1°/min jusqu'à atteindre un palier à 230°C, d'une durée de 4h. Une rampe de descente en température à 1°/min est ensuite opérée jusqu'à 100°C avant de sortir la structure amincie 6' du four. La structure amincie 6' subit ensuite une seconde étape d'amincissement de la couche amincie 2' jusqu'à une épaisseur de 10 microns pour former la couche utile 20.

La structure hybride 60 ainsi obtenue est intègre et présente une interface de collage 5 consolidée dont l'énergie de collage est supérieure ou égale à 1000mJ/m$^2$, une couche utile 20 intègre ne comportant pas de dégradation liée à des phénomènes de « buckling » et ce malgré la présence de zones non collées à son interface, d'une taille comprise entre 100 et 500 microns. Une telle structure hybride 60 peut ensuite être utilisée pour l'élaboration de dispositifs à ondes acoustiques.

Exemple 2 :

Un substrat support 1 en silicium (Si) de 150mm de diamètre d'épaisseur 725 microns et comportant une couche d'oxyde sur sa face à assembler est collé par adhésion moléculaire avec un substrat donneur 2 en tantalate de lithium (LiTaO$_3$) de même diamètre pour fournir la structure collée 6. Une étape de contrôle par microscopie acoustique permet de détecter deux défauts de collage (zones non collées) à l'interface de collage 5, dont la taille maximale correspond à un rayon r de 700 microns.

La structure hybride 60 finale attendue comporte une couche utile 20 de 10 microns et un substrat support de 725 microns. La température de recuit à appliquer est 250°C, dans le but de consolider suffisamment l'interface de collage 5 pour que la structure hybride 60 supporte les étapes ultérieures d'élaboration des dispositifs à ondes acoustiques.

L'étape a') permet de déterminer des épaisseurs seuil et plafond : $h_{2seuil}$ = 28 $\mu$m et $h_{2plafond}$ = 25 $\mu$m. La fourchette d'épaisseur obtenue n'est pas compatible avec la structure hybride 60 attendue, l'épaisseur seuil étant supérieure à l'épaisseur plafond.

L'étape a") de recyclage est alors opérée, dans le but de diminuer la taille maximale des défauts de collage présents à l'interface de collage 5 : l'insertion d'un outil en forme de biseau au niveau de l'interface de collage 5 de la structure collée 6 permet de séparer les substrats donneur 2 et support 1. Une nouvelle séquence de nettoyage et d'activation de surface des deux substrats est effectuée avant un nouvel assemblage, pour fournir une nouvelle structure collée 6. Une nouvelle étape de contrôle par microscopie acoustique permet de détecter dix défauts à l'interface de collage 5, dont la taille maximale correspond à un rayon r de 150 microns.

Sur la base des nouvelles caractéristiques de la structure collées 6, l'étape a') permet de déterminer les épaisseurs seuil et plafond suivantes : $h_{2seuil}$ = 20 $\mu$m et $h_{2plafond}$ = 25 $\mu$m. La fourchette d'épaisseur obtenue est maintenant compatible avec la structure hybride 60 attendue, l'épaisseur seuil étant inférieure à l'épaisseur plafond et l'épaisseur utile étant inférieure à ladite fourchette.

L'étape b) d'amincissement, consistant en un amincissement mécanique suivi d'un polissage mécano-chimique et d'un nettoyage chimique, permet de former une couche amincie 2' dont l'épaisseur intermédiaire est de 23 microns. Le traitement thermique de l'étape c) est ensuite effectué. L'entrée dans le four s'effectue à 70°C, la rampe de montée en température est de 1°/min jusqu'à atteindre un palier à 250°C, d'une durée de 4h. Une rampe de descente en température à 1°/min est ensuite opérée jusqu'à 100°C avant de sortir la structure du four. La structure amincie 6' subit ensuite une seconde étape d'amincissement de la couche amincie 2' jusqu'à une épaisseur utile de 10 microns pour former la couche utile 20.

La structure hybride 60 ainsi obtenue est intègre et présente une interface de collage 5 consolidée dont l'énergie de collage est supérieure ou égale à 1000mJ/m$^2$, voire même supérieure à 1500mJ/m$^2$ ; elle présente également une couche utile 20 intègre ne comportant pas de dégradation liée à des phénomènes de « buckling » et ce malgré la présence de zones non collées à son interface d'une taille comprise entre 50 et 150 microns. Une telle structure hybride 60 peut ensuite être utilisée pour l'élaboration de dispositifs à ondes acoustiques.

Bien entendu, l'invention n'est pas limitée aux seuls modes de mise en oeuvre et exemples décrits et on peut y apporter des variantes de réalisation sans sortir du cadre de l'invention tel que défini par les revendications.

## Revendications

**1.** Procédé de fabrication d'une structure hybride (60) comportant une couche utile (20) de matériau piézoélectrique présentant une épaisseur utile disposée sur un substrat support (1) présentant une épaisseur support et un coefficient de dilatation thermique inférieur à celui de la couche utile (20), le procédé comprenant :

a) Une étape de fourniture d'une structure collée (6) comportant un substrat donneur (2) de matériau piézoélectrique et le substrat support (1), la structure collée (6) présentant une interface de collage (5) entre ces deux substrats ;

b) Une première étape d'amincissement du substrat donneur (2) pour former une couche amincie (2'), présentant une épaisseur intermédiaire, disposée sur le substrat support (1) ; l'ensemble formant une structure amincie (6') ;

c) Une étape de traitement thermique de la structure amincie (6') à une température de recuit;

d) Une seconde étape d'amincissement, après l'étape c), de la couche amincie (2') pour former la couche utile (20) ;

le procédé étant **caractérisé en ce qu'**il comprend, préalablement à l'étape b), une étape a') de détermination d'une fourchette d'épaisseurs intermédiaires évitant une dégradation de la structure amincie (6') lors de l'étape c), la fourchette étant définie par une épaisseur seuil et une épaisseur plafond, et l'épaisseur intermédiaire de la couche amincie (2') étant choisie dans cette fourchette.

2. Procédé de fabrication d'une structure hybride (60) selon la revendication précédente, dans lequel l'épaisseur seuil est déterminée à partir d'un premier modèle de sensibilité dont des paramètres d'entrée incluent l'épaisseur support, les coefficients de dilatation thermique du substrat donneur (2) et du substrat support (1), la température de recuit et une taille maximale de zones non collées présentes à l'interface de collage (5) de la structure collée (6).

3. Procédé de fabrication d'une structure hybride (60) selon l'une des revendications précédentes, dans lequel l'épaisseur plafond est déterminée à partir d'un second modèle de sensibilité dont des paramètres d'entrée incluent l'épaisseur support, les coefficients de dilatation thermique du substrat donneur (2) et du substrat support (1) et la température de recuit.

4. Procédé de fabrication d'une structure hybride (60) selon l'une des revendications précédentes, comprenant après l'étape a') et préalablement à l'étape b), une étape a") de recyclage de la structure collée (6), quand l'étape a') de détermination établit l'épaisseur seuil supérieure à l'épaisseur plafond ou l'épaisseur plafond inférieure à l'épaisseur utile.

5. Procédé de fabrication d'une structure hybride (60) selon la revendication précédente, dans lequel l'étape a") de recyclage comprend un décollement au niveau de l'interface de collage (5) de la structure collée (6).

6. Procédé de fabrication d'une structure hybride (60) selon la revendication précédente, dans lequel l'étape a") de recyclage comprend la réutilisation des substrats donneur (2) et support (1) issus du décollement pour une nouvelle étape a) de fourniture d'une structure collée (6).

7. Procédé de fabrication d'une structure hybride (60) selon l'une des revendications précédentes, dans lequel la seconde étape d'amincissement d) peut en outre comprendre une étape d'amincissement du substrat support (1).

8. Procédé de fabrication d'une structure hybride (60) selon l'une des revendications précédentes, dans lequel la couche utile (20) est composée d'un matériau choisi dans le groupe : tantalate de lithium ($LiTaO_3$), niobate de lithium ($LiNbO_3$), nitrure d'aluminium (AlN), oxyde de zinc (ZnO).

9. Procédé de fabrication d'une structure hybride (60) selon l'une des revendications précédentes, dans lequel le substrat support (1) est composé d'un matériau choisi dans le groupe : silicium, semi-conducteurs III-V, carbure de silicium, verre, saphir.

10. Procédé de fabrication d'une structure hybride (60) selon la revendication précédente, dans lequel le substrat support (1) comprend une ou plusieurs couches superficielles.

**Patentansprüche**

1. Verfahren zur Herstellung einer Hybridstruktur (60), welche eine Nutzschicht (20) aus piezoelektrischem Material mit einer Nutzdicke umfasst, welche auf einem Trägersubstrat (1) angeordnet ist, das eine Trägerdicke und einen Wärmeausdehnungskoeffizienten kleiner dem Wärmeausdehnungskoeffizienten der Nutzschicht (20) aufweist, wobei das Verfahren folgendes umfasst:

a) einen Schritt der Bereitstellung einer geklebten Struktur (6), die ein Donorsubstrat (2) aus piezoelektrischem Material und das Trägersubstrat (1) umfasst, wobei die geklebte Struktur (6) eine Klebegrenzfläche (5) zwischen diesen beiden Substraten aufweist;
B) einen ersten Schritt zur Verdünnung des Donorsubstrats
(2) zur Bildung einer verdünnten Schicht (2') mit einer Zwischendicke, die auf dem Trägersubstrat (1) angeordnet ist; wobei die Anordnung eine verdünnte Struktur (6') bildet;
c) einen Schritt der Wärmebehandlung der verdünnten Struktur (6') bei einer Glühtemperatur;

d) einen zweiten Schritt der Verdünnung der verdünnten Schicht (2') nach Schritt c),

um die Nutzschicht zu bilden (20);
wobei das Verfahren **dadurch gekennzeichnet ist, dass** es vor Schritt b) einen Schritt a') zur Bestimmung eines Bereichs von Zwischendicken umfasst, der eine Beschädigung der verdünnten Struktur (6') in Schritt c) verhindert, wobei der Bereich durch eine Grenzdicke und eine Höchstdicke definiert ist und die Zwischendicke der verdünnten Schicht (2') in diesem Bereich ausgewählt wird.

2. Verfahren zur Herstellung einer Hybridstruktur (60) nach dem vorhergehenden Anspruch, in dem die Grenzdicke anhand eines ersten Sensitivitätsmodell bestimmt wird, dessen Eingangsparameter die Trägerdicke, die Wärmeausdehnungskoeffizienten des Donorsubstrats (2) und des Trägersubstrats (1), die Glühtemperatur und eine maximale Größe von nicht geklebten Bereichen an der Klebegrenzfläche (5) der geklebten Struktur (6) beinhalten.

3. Verfahren zur Herstellung einer Hybridstruktur (60) nach einem der vorhergehenden Ansprüche, in dem die Höchstdicke anhand eines zweiten Sensitivitätsmodells bestimmt wird, dessen Eingangsparameter die Trägerdicke, die Wärmeausdehnungskoeffizienten des Donorsubstrats (2) und des Trägersubstrats (1) sowie die Glühtemperatur beinhalten.

4. Verfahren zur Herstellung einer Hybridstruktur (60) nach einem der vorhergehenden Ansprüche, welche nach Schritt a') und vor Schritt b) einen Schritt a") des Recyclings der geklebten Struktur (6)umfasst, wenn in Schritt a') eine Grenzdicke größer der Höchstdicke bestimmt oder eine Höchstdicke kleiner der Nutzdicke bestimmt wird.

5. Verfahren zur Herstellung einer Hybridstruktur (60) nach dem vorhergehenden Anspruch, in dem der Recyclingschritt (a") das Ablösen der geklebten Struktur (6) an der Klebegrenzfläche (5) umfasst.

6. Verfahren zur Herstellung einer Hybridstruktur (60) nach dem vorhergehenden Anspruch, in dem Recyclingsschritt a") die Wiederverwendung des Donorsubstrats (2) und des Trägersubstrats (1) nach dem Ablösen in einem neuen Schritt a) zur Bereitstellung einer geklebten Struktur (6) umfasst.

7. Verfahren zur Herstellung einer Hybridstruktur (60) nach einem der vorhergehenden Ansprüche, in dem der zweite Verdünnungsschritt d) des Weiteren einen Schritt der Verdünnung des Trägersubstrats (1) umfassen kann.

8. Verfahren zur Herstellung einer Hybridstruktur (60) nach einem der vorhergehenden Ansprüche, in dem sich die Nutzschicht (20) aus einem Material zusammensetzt, das aus der Gruppe bestehend aus Lithiumtantalat (LiTaCc), Lithiumniobat (LiNbCc), Aluminiumnitrid (AIN) und Zinkoxid (ZnO) ausgewählt wird.

9. Verfahren zur Herstellung einer Hybridstruktur (60) nach einem der vorhergehenden Ansprüche, in dem sich die Trägerschicht (1) aus einem Material zusammensetzt, das aus der Gruppe bestehend aus Silizium, III-V-Halbleitern, Siliziumkarbid, Glas und Saphir ausgewählt wird.

10. Verfahren zur Herstellung einer Hybridstruktur (60) nach dem vorhergehenden Anspruch, in dem das Trägersubstrat (1) eine oder mehrere Oberflächenschichten umfasst.

**Claims**

1. A method for manufacturing a hybrid structure (60) comprising an effective layer (20) of piezoelectric material that has an effective thickness arranged on a supporting substrate (1) that has a supporting thickness and a coefficient of thermal expansion lower than that of the effective layer (20), the method comprising:

a) A step of providing a bonded structure (6) comprising a piezoelectric material donor substrate (2) and the supporting substrate (1), the bonded structure (6) having a bonding interface (5) between these two substrates;
b) A first step of thinning the donor substrate
b) A first step of thinning the donor substrate (2) to form a thinned layer (2'), that has an intermediate thickness, arranged on the supporting substrate (1); the assembly forming a thinned structure (6');
c) A step of heat treating the thinned structure (6') at an annealing temperature;
d) A second step, after step c), of thinning

the thinned layer (2') to form the effective layer (20) ;

the method being **characterized in that** it comprises, prior to step b), a step a') of determining a range of intermediate thicknesses that prevent the thinned structure (6') from being damaged during step c), the range being defined by a threshold thickness and a maximum thickness, and the intermediate thickness of the thinned layer (2') being selected from within this range.

2. A method for manufacturing a hybrid structure (60) according to the preceding claim, wherein the threshold thickness is determined from a first sensitivity model, the input parameters of which include the supporting thickness, the coefficients of thermal expansion of the donor substrate (2) and the supporting substrate (1), the annealing temperature and a maximum size of unbonded areas found at the bonding interface (5) of the bonded structure (6).

3. A method for manufacturing a hybrid structure (60) according to one of the preceding claims, wherein the maximum thickness is determined from a second sensitivity model, the input parameters of which include the supporting thickness, the coefficients of thermal expansion of the donor substrate (2) and the supporting substrate (1) and the annealing temperature.

4. A method for manufacturing a hybrid structure (60) according to one of the preceding claims, comprising, after step a') and prior to step b), a step a") of recycling the bonded structure (6), when the step a') of determining sets the threshold thickness higher than the maximum thickness or the maximum thickness lower than the effective thickness.

5. 5. A method for manufacturing a hybrid structure (60) according to the preceding claim, wherein the step a") of recycling comprises a detachment at the bonding interface (5) of the bonded structure (6).

6. 6. A method for manufacturing a hybrid structure (60) according to the preceding claim, wherein the step a") of recycling comprises the reuse of the donor (2) and supporting (1) substrates obtained from the detachment for a new step a) of providing a bonded structure (6).

7. A method for manufacturing a hybrid structure (60) according to one of the preceding claims, wherein the second step d) of thinning may further comprise a step of thinning the supporting substrate (1).

8. A method for manufacturing a hybrid structure (60) according to one of the preceding claims, wherein the effective layer (20) is composed of a material selected from the group: lithium tantalate (LiTaCc), lithium niobate (LiNbCc), aluminium nitride (AlN), zinc oxide (ZnO).

9. A method for manufacturing a hybrid structure (60) according to one of the preceding claims, wherein the supporting substrate (1) is composed of a material selected from the group: silicon, semiconductors III-V, silicon carbide, glass, sapphire.

10. A method for manufacturing a hybrid structure (60) according to the preceding claim, wherein the supporting substrate (1) comprises one or more surface layer (s) .

FIG.1a

FIG.1b

FIG.1c

FIG.2a

FIG.2b

FIG.2c

**Etape a'')** : Recyclage de la structure collée (6)

**Etape a)** : Fourniture d'une structure collée (6)

Modèles de sensibilité

**Etape a')** : Détermination d'une fourchette d'épaisseurs pour la couche amincie (2')

Fourchette épaisseurs compatible

Fourchette épaisseurs non compatible

**Etape b)** : Amincissement du substrat donneur (2) pour former la couche amincie (2') de la structure amincie (6')

**Etape c)** : Traitement thermique appliqué à la structure amincie (6')

**Etape d)** : Amincissement de la couche amincie (2') pour former la couche utile (20) de la structure hybride (60)

FIG.3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2015042207 A

**Littérature non-brevet citée dans la description**

- **K.HASHIMOTO, M.KADOTA et al.** Recent development of temperature compensated SAW devices. *IEEE Ultrason. Symp. 2011,* 2011, 79-86